# EUROPEAN PATENT SPECIFICATION

(11) **EP 0 789 390 B1**
(45) Date of publication and mention of the grant of the patent: **13.08.2003**
(21) Application number: 97200966.6
(22) Date of filing: 12.01.1990
(51) Int. Cl.: H01L 21/48, H01L 25/16, H05K 1/16

(54) **A method for producing a multilayer hybrid circuit**
Verfahren zur Herstellung einer mehrschichtigen hybriden Schaltung
Méthode de production d'un circuit hybride multi-couche

(30) Priority: 14.01.1989 JP 737889
(43) Date of publication of application: 13.08.1997
(62) Divisional of application: 90400092.4
(73) Proprietor: TDK Corporation, Chuo-ku, Tokyo (JP)
(72) Inventor: Takaya, Minoru, Ichikawa-shi, Chiba (JP); Mochizuki, Yoshinori, Ichikawa-chi, Chiba (JP)
(74) Representative: Poulin, Gérard

(56) References cited:
- EP-A- 0 111 890
- EP-A- 0 297 565
- US-A- 4 322 698
- US-A- 4 730 241
- PATENT ABSTRACTS OF JAPAN vol. 009, no. 035 (E-296), 14 February 1985 & JP 59 178768 A (TDK KK), 11 October 1984,
- PATENT ABSTRACTS OF JAPAN vol. 007, no. 094 (E-171), 20 April 1983 & JP 58 018952 A (TOKYO DENKI KAGAKU KOGYO KK), 3 February 1983,
- PATENT ABSTRACTS OF JAPAN vol. 008, no. 176 (E-260), 14 August 1984 & JP 59 068959 A (TDK KK), 19 April 1984,
- PATENT ABSTRACTS OF JAPAN vol. 010, no. 179 (E-414), 24 June 1986 & JP 61 027655 A (KAZUYOSHI SONE), 7 February 1986,

## Description

### BACKGROUND OF THE INVENTION

The present invention relates to an improvement of a multilayer hybrid circuit which has a laminated printed circuit board including, at least, an inductor and/or a capacitor and/or a resistor in the printed circuit board itself.

Conventionally, electronic components are mounted on the surface of a printed circuit board, and the wiring among the components are effected through a printed wiring on the board. The Japanese Patent Application JP 59 178 768 A shows a multilayer hybrid circuit comprising external terminals on the outer periphery of the multilayer substrate. However, the high density mounting of electronic components requires the improvements for mounting components.

The USP 4,322,698 provides one solution for high density mounting, and discloses a multilayer hybrid circuit which has a laminated printed circuit board which includes an inductor, a capacitor and/or a resistor. Since those components are produced in a board (not on the surface of the board), the size of the system can be miniturized, and the high density mounting has become possible.

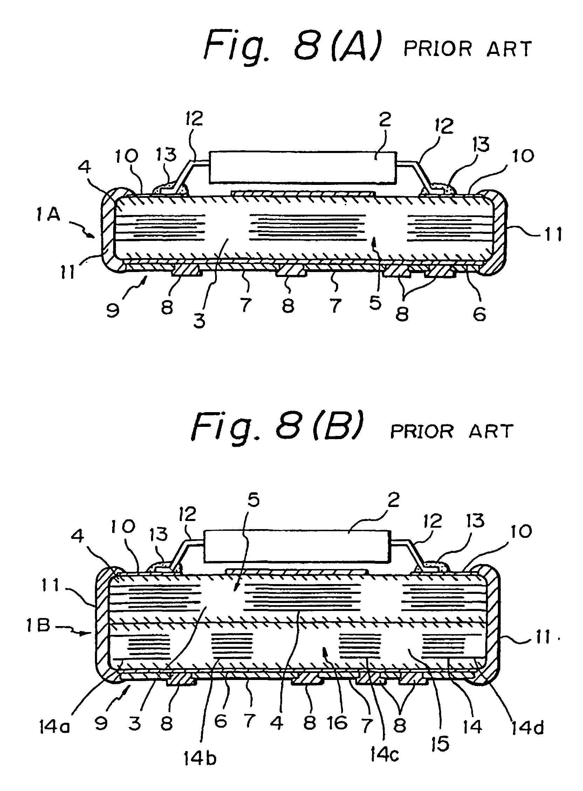

Fig.8A and 8B show such prior multilayer hybrid circuits. In Fig.8A, a laminated body 1A has a plurality of dielectric laminated layers 3 and a plurality of conductive films 4 so that those conductive films 4 and those dielectric layers 3 compose a plurality of capacitors 5. A glass layer 6 is attached on at least one surface of the laminated body 1A, and a resistor network 9 which has a resistor layer 8 and a conductive layer 7 is attached on said glass layer 6. A printed wiring pattern 10 is deposited on at least one surface of the laminated body 1A, and a plurality of terminals 11 for external connection are deposited on the sides of the laminated body 1A. The conductive pattern 10 is used for mounting an electronic component 2 (for instance an integrated circuit, or a transistor) on the laminated body 1A. The lamainated body 1A is produced through thick film printing process, and sintering process. An external electronic component 2 is soldered on the conductive pattern 10 by soldering a terminal wire 12 of the component 10 to the conductive pattern 10 by the solder 13.

In the prior structure of Fig.8B, the laminated body 1B has not only capacitors and resistors, but also inductors 16 having an internal conductor 14 and a ferrite layer 15. In producing an inductor, an U-shaped conductive pattern 14a is printed, next a ferrite pattern which is dielectric is deposited so that a window is kept at the one end of said U-shaped pattern 14a. Next, another U-shaped conductive pattern 14b is deposited on the ferrite pattern so that end of the pattern 14a at the window of the ferrite pattern is connected to the end of the second pattern 14b. Thus, a one turn coil is produced by a pair of U-shaped conductive patterns 14a and 14b. By repeating the above process, an inductor with a plurality of turns 14a and 14b is produced. Similarly, another inductor having U-shaped patterns 14c and 14d is produced.

However, a prior multilayer hybrid circuit has the following disadvantages.
(a) First, conventionally, a wiring between a surface component, and a capacitor 5, an inductor 16, or, a resistor 9, is effected by using a surface printed conductive pattern 10 and a side terminal 11 deposited on the surface of the laminated body. However, when a complicated external component 2 which has many external wiring pins is mounted on the board, the wiring pattern 10 must also be complicated. Thus, the area or the size of the board for the wiring pattern must be large, and sometimes that area required for wiring is larger than the area for mounting internal passive components. Further, a large number of side terminals 11 must be provided, and the insulation between the side terminals 11 is difficult when the side terminals 11 are so densed.
(b) Secondly, an external component 2 is attached on the board through conventional wiring process, and the board 1A or 1B is mounted on a mother board by soldering side terminals 11 to a printed pattern on the mother board. In that structure, the component 2 is supported by the wire 12 of the component 2 itself. However, that structure has the disadvantage that the complicated fine surface pattern 10 on the surface of the board is difficult.
(c) Further, since the structure of a multilayer hybrid circuit is so sophiscated, it is mechanically weak, and is easily damaged. In particular, when a multilayer hybrid circuit is mounted on a conventional printed mother board, a small deformation of a printed mother board would then apply a significant amount of stress to a multilayer hybrid circuit board, and damage the same.
(d) Because of the above disadvantages, the density of electronic components on a laminated hybrid circuit is not enough.

### SUMMARY OF THE INVENTION

It is an object, therefore, of the present invention to provide a new and improved multilayer hybrid circuit by overcoming the disadvantages and limitations of a prior multilayer hybrid circuit.

It is also an object of the present invention to provide a multilayer hybrid circuit which mounts densed components with densed wiring.

The above and other objects are attained by a method of producing a multilayer hybrid circuit comprising an essentially flat-shaped laminated body which includes a resistor and at least one selected from capacitor and an inductor, and inner wiring portion; and a plurality of side terminals provided on side walls of said laminated body for external connection of said capacitor, said inductor, and said resistor; said capacitor being composed of a dielectric layer and conductive layers coupled with said side terminal; said inductor being composed of a magnetic layer and a plurality of U-shaped conductive layers composing a coil by sandwiching said magnetic layer between each U-shaped conductive layers; said resistor being composed of a dielectric layer and a resistor layer deposited on said dielectric layer together with a conductive layer for coupling said resistor layer with one of said side terminals; said inner wiring portion having at least one dielectric layer, a conductive pattern deposited on said dielectric layer, and a conductive through hole penetrating a dielectric layer for connecting conductive patterns on different dielectric layers, and said conductive pattern being coupled with said side terminals; and an electronic component mounted on said laminated body so that a wiring for said electronic component is effected through said inner wiring portion.

Said electronic component is preferably a bare chip, and is molded by plastics with the multilayer hybrid circuit itself.

According to the invention the method for producing a multilayer hybrid circuit comprises the steps given in claim 1.

### BRIEF DESCRIPTION OF THE DRAWINGS

The foregoing and other objects, features, and attendant advantages of the present invention will be appreciated as the same become better understood by means of the following description and accompanying drawings wherein;
Fig.1 shows a cross section of a multilayer hybrid circuit according to the present invention,
Fig.2A is a perspective view of another embodiment of a multilayer hybrid circuit according to the present invention,
Fig.2B is a cross section of the multilayer hybrid circuit of Fig.2A,
Fig.3A is a perspective view of still another embodiment of a multilayer hybrid circuit according to the present invention,
Fig.3B is a cross section of Fig.3A,
Fig.4 shows a cross section of another embodiment of the multilayer hybrid circuit according to the present invention,
Fig.5A is an example of a circuit diagram produced in a structure of Figs.3A and 3B,
Fig.5B is another example of a circuit diagram produced in a structure of Figs.3A and 3B,
Fig.6A is a plane view of still another embodiment of the present invention,
Fig.6B is a side cross section of Fig.6A,
Fig.6C is a side cross section of Fig.6A, and shows the mounting of the multilayer hybrid circuit to a mother board,
Fig.6D is a partially enlarged view of Fig.6C,
Fig.7A is a cross section of still another embodiment of the present invention,
Fig.7B is a partially enlarged view of Fig.7A,
Fig.8A is a cross section of a prior multilayer hybrid circuit, and
Fig.8B is a cross section of another prior multilayer hybrid circuit.

### DESCRIPTION OF THE PREFERRED EMBODIMENTS

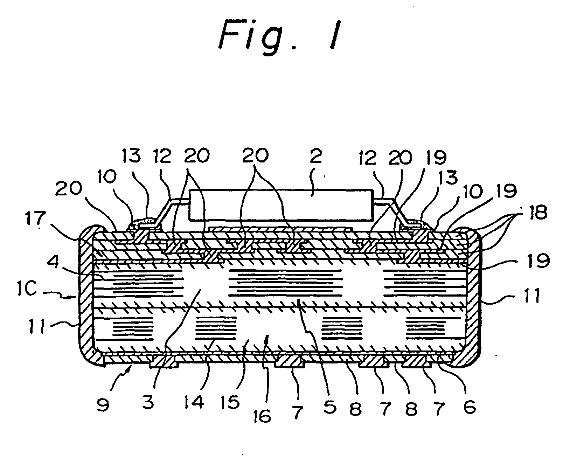

Fig.1 shows a cross section of a multilayer hybrid circuit produced by the method of the present invention in which the same reference numerals as those in Figs.8A and 8B show the same members. The numeral 17 is an inner wiring portion mounted on a capacitor portion 5. The inner wiring portion 17 has at least one insulation layer 18 (three insulation layers 18 are shown in Fig.1), a flat conductive layer 19 deposited on said insulation layer 17, and a through hole 20 which penetrates through insulation layers 17 for electrically coupling said flat conductive patterns 19 on different layers. Of course, the conductive layers 19 and the through holes 20 are provided depending upon the desired wiring pattern of an electrical circuit.

The inner wiring portion 17 couples also a surface pattern 10 which a pin 12 of an external component 2 is connected, with a side terminal 11 which inner passive components (an inductor, a capacitor, and/or a resistor) is connected. The conductive material for a through hole conductor 20, and a flat conductive layer 19 is Ag, Ag-Pd, or Pd. The insulation layer 18 is for instance made of ceramics, ferrite or glass. The inner wiring portion 17 is produced through thick film printing process, and the sintering process, as is the case of a laminated body 1C.

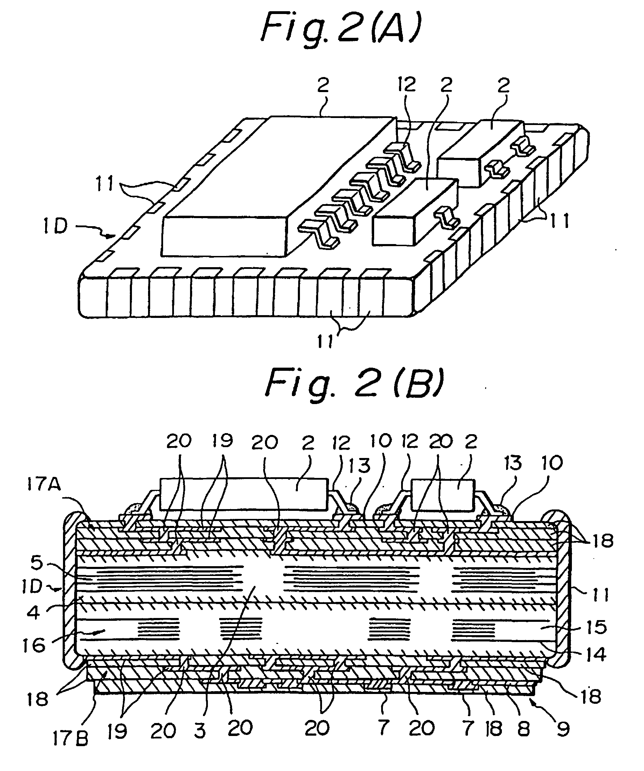

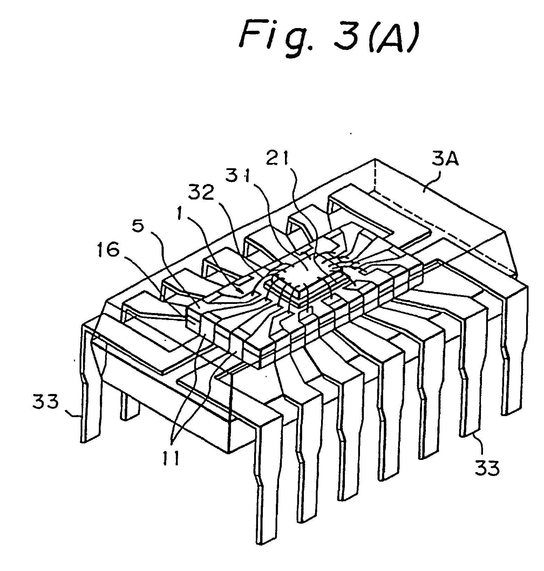

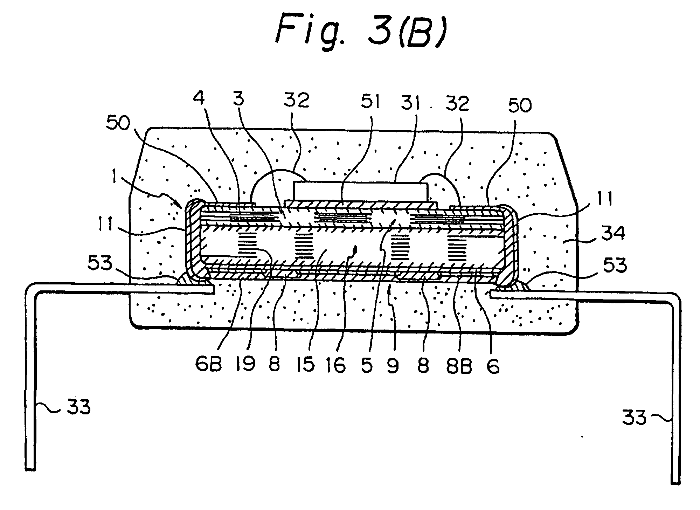

Figs.2 and 3 show another multilayer hybrid circuit produced by the method of the present invention, in which a laminated body 1D has a first inner wiring portion 17A on one surface of the laminated body 1D, and a second inner wiring portion 17B on the other surface of the laminated body 1D. A plurality of external components 2 are mounted on the first surface of the laminated body 1D. The first inner wiring portion 17A effects the connection not only between external components 2 and side terminals 11, but also between the external components themselves. The second inner wiring portion 17B effects the connection between the resistor network 9 and side terminals 11.

Further, it should be noted that further external components may be mounted on the second inner wiring portion 17. In that case, the connection between said further comopnents and side terminals is effected by the second inner wiring portion 17B.

It should be appreciated that the inner wiring portion 17, 17A, or 17B is useful to connect not only between external components 2 and side terminals 11, but also between inductors, capacitors and resistors mounted in the laminated body. Further, the connection between an external component 2 and an inner component (an inductor, a capacitor, and/or a resistor) is effected by the inner wiring portion 17, without using side terminals 11.

It should be noted that the layers are classified to an inner wiring portion, a capacitor portion, an inductor portion, and a resistor portion in the thickness direction of the layers. The latter three portions include a plurality of electronic components in each portion.

Figs.3A and 3B show another multilayer hybrid circuit produced according to the method of the present invention, and Fig.3A is a perspective view and Fig.3B is a cross section of Fig.3A.

In those figures, the numeral 1 shows a laminated body which is similar to that of 1C in Fig.1, and 1D in Fig.2. The laminated body 1 has a capacitor 5 and/or an inductor 16. The laminated body 1 also includes a resistor and an inner wiring portion. The capacitor 5 is produced by laminating a dielectric layer 3 and a conductive film 4, and an terminal of each capacitor is coupled with a side terminal 11 for external connection. An inductor 16 is produced by a ferrite layer 15 and a conductive layer 19 through thick film printing process so that conductive film 19 forms a coil. It should be appreciated that a transformer is also possible by arranging conductive layer and ferrite layer in a laminated body.

A resistor network 9 is provided on the rear portion of the body 1. The resistor network 9 comprises a resistor layer 8 and a conductive layer 8B deposited on a glass layer 6 which is provided on the rear portion of the body 1. The resistor network 9 is covered with the glass layer 6B for protection purposes. The resistor network may be provided on both the surfaces of the laminated body 1, although Fig.3B shows the case that the resistor network is provided on only the rear surface of the laminated body 1. The numeral 50 is a pad provided on a surface of the body 1 for bonding of an IC.

The laminated body 1, the resistor network 9, the pad 50 and the side terminal 11 are sintered at about 800 °C.

The numeral 51 shows a conductive film which is deposited on the sintered laminated body 1, and the numeral 31 is a bare chip adhered on said conductive film 51. The bare chip 31 is for instance a semiconductor or an integrated circuit bare chip. The conductive film 51 is produced through a thick film printing process, an evaporation process, or sputtering process of metal (silver, copper, aluminium, molybudenum, gold, or palladium).

The bare chip 31 is fixed on the laminated body through the steps of printing conductive paste on the laminated body 1 through thick film printing process, placing a bare chip 31 on said paste, and heating the body at 150-160 °C. That process provides the conductive film and the adhesion of a bare chip simultaneously. The numeral 32 is a conductive wire made of gold for bonding a bare chip 31 to a pad 50. It should be noted that bare chips may be mounted on both the surfaces of the laminated body 1, although Fig.3 shows the case that a bare chip is mounted on only one surface of the body 1.

After the bare chip 31 is mounted on the laminated body 1, the laminated body 1 is placed on a lead frame so that a side terminal 11 is placed on a proper lead terminal 33 of a lead frame. The side terminal 11 of the laminated body 1 is conductively fixed to the lead terminal 33 of the lead frame by using conductive paste or solder 53. Then, the laminated body 1 is molded by plastics 4 which covers the laminated body 1, the bare chip 31, the bonding wire 32, and a part of the lead terminal 33. Finally, an outer portion (not shown) of a lead frame is removed.

The connection of the bare chip is not restricted to bonding of gold wire, but Tape Automated Bonding (TAB system) and conventional soldering are possible. Further, in some cases, the molding process by plastics may be omitted.

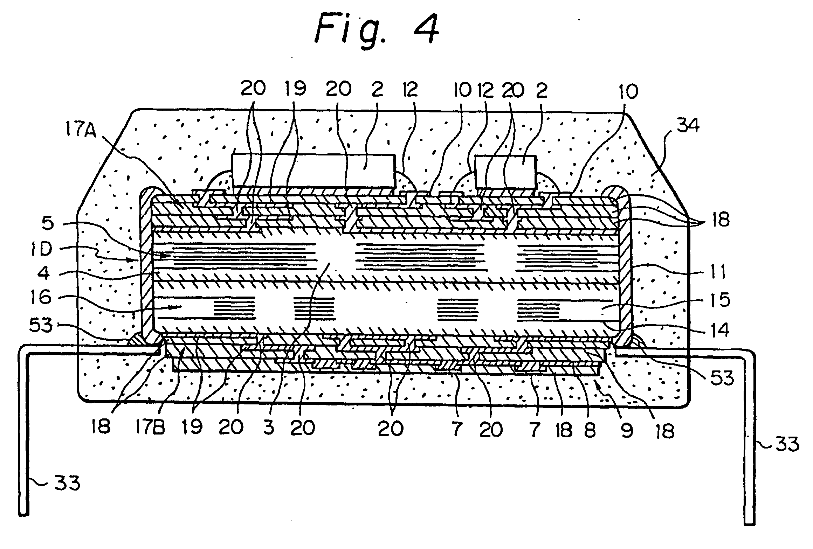

Fig.4 shows another multilayer hybrid circuit produced by the method of the present invention, in which a plurality of bare chips 2 are mounted on a laminated body 1D of Fig.2B, and the whole body including the laminated body 1D and the bare chips are molded with plastics 34, and the side terminals 11 are coupled with lead terminals 33.

In the above circuits of Figs.3 and 4, a bare chip, and inner components including a capacitor, an inductor and a resistor are connected to each other through the side terminal 11, and/or an inner wiring portion.

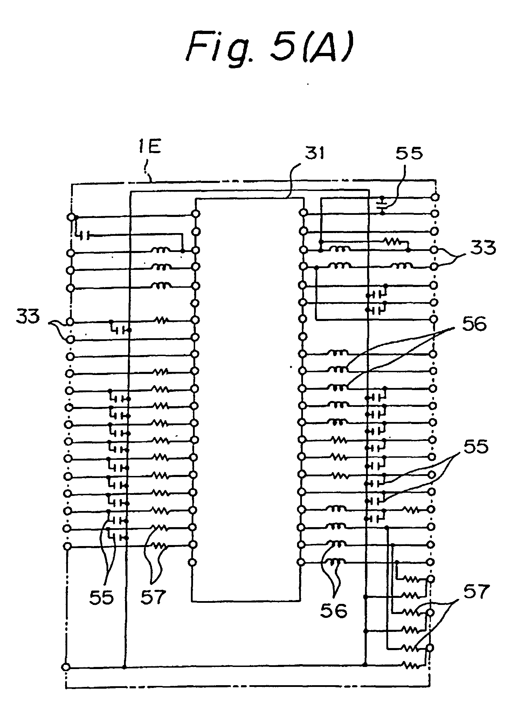

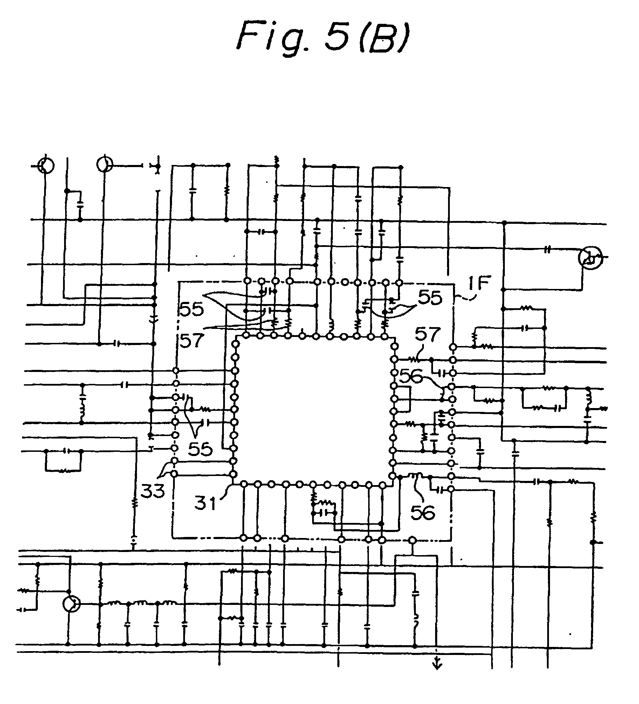

Figs.5A and 5B show some examples of circuit diagrams of the hybrid circuit according to the present invention, in which a bare chip 31 which is an active device, and passive devices including a capacitor 55, an inductor 56, and/or a resistor 57 enclosed by dotted line 1E are included in a single chip. The numeral 33 shows a lead terminal for external connection of a hybrid integrated circuit.

A bare chip 31 is fixed on a laminated body 1 directly, or through a conductive film 51. The conductive film 51 functions as a heat sink. The coefficient of heat transfer of titanium-oxide porcelain and Barium-titanate porecelain is 0.0067w/cm·°C, and 0.0028 w/cm·°C, respectively. On the other hand, those values of silver and copper are 4.10w/cm·°C, and 3.80w/cm·°C, respectively. Therefore, the use of the conductive film 51 of silver or copper effects the dissipation of heat generated in a bare chip 31, and prevents the overheat or high temperature of a bare chip.

As described, the circuits of Figs.3 and 4 have the feature that an active element by a semiconductor bare chip and a passive element by a laminated body are mounted in a single hybrid circuit chip, which is molded together. Therefore, it is not necessary to mount passive elements on a printed circuit board which mounts a semiconductor chip, and the number of components is considerably reduced. Further, no printed pattern on a printed circuit board for coupling an active element and a passive element is necessary, and therefore, the structure of a printed pattern is simplified.

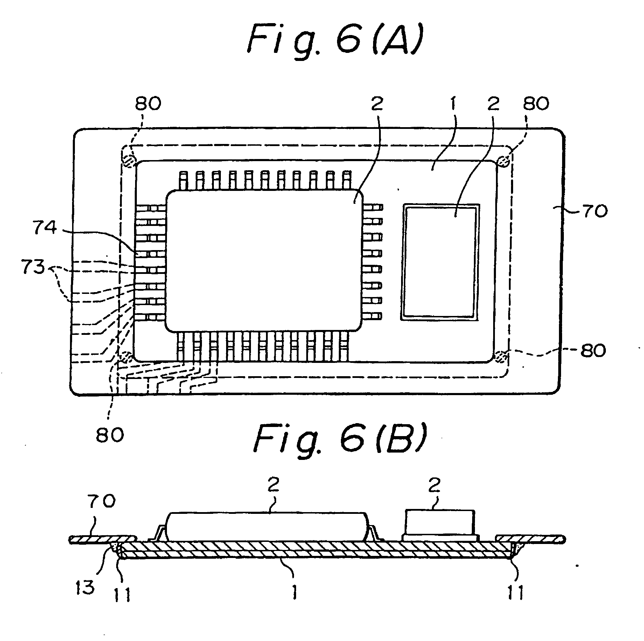

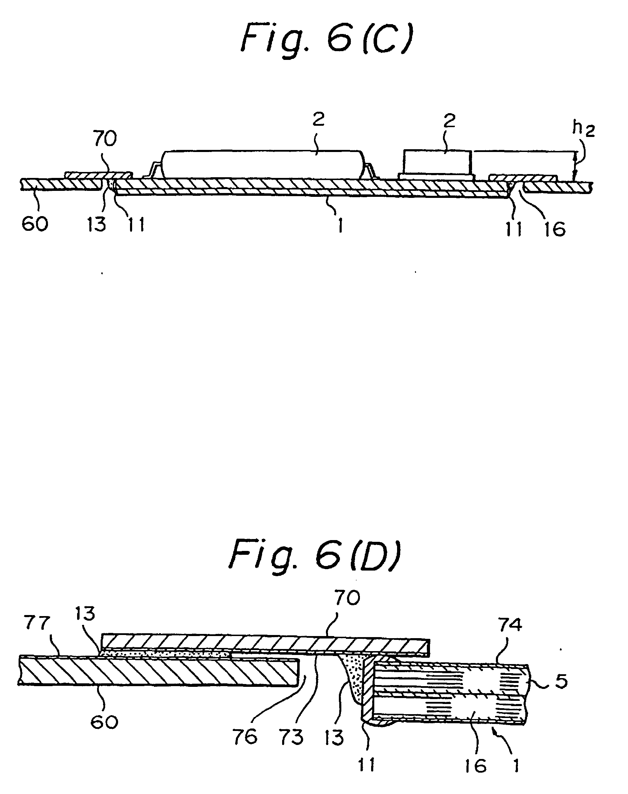

Figs.6A and 6B show another multilayer hybrid circuit produced according to the method of the present invention. Fig.6A shows a plane view, Fig.6B shows a cross section of the same, Fig.6C shows the cross section of Fig.6A and shows the connection to a mother board, and Fig.6D shows a partially enlarged view of Fig.6C. The feature of that embodiment in Figs.6A through 6D is the use of a relay board 70 between a mother board 60 and a laminated body 1. The relay board 70 is made of resilient plastics board 70 and conductive patterns 73 printed on that relay board 70.

The relay board 70 has a hole or a window which relates to a laminated body 1. Therefore, the shape of the relay board 70 is in ring-shaped. The conductive pattern 73 on the relay board 70 is soldered to the related conductive pattern 74 or the side terminal 11 of the laminated body 1 through the solder 13. The window of the relay board 70 is preferably a little smaller than the area of the laminated body 1, so that the laminated body 1 is placed on the ring-shaped relay board 70.

The mother board 60 has a window 76 which is a little larger than the area of the relay board 70 so that the relay board 70 is positioned in that window with a small spacing (for instance that spacing is 0.2 mm). The conductive pattern 73 on the relay board 70 is connected to the conductive pattern 77 on the mother board 60 through the solder 13. The laminated body 1 is preferably fixed to the relay board 70 by using adhesive 80 so that the laminated body 1 is positioned correctly during the soldering operation.

When a laminated body 1 is mounted on a mother board through a relay board which is resilient, even if a stress is applied to a mother board, said stress is absorbed by the resilient relay board, and no stress is applied to the laminated body 1, and further, no excessive stress is applied to the solder and therefore the connection by solder is not damaged.

Because of the presence of a window 76 of a mother board, the height h2 between the top of a component and the surface of the mother board may be lower than that when no window is provided. Of course, a mother board with no window is possible if that height of a component is not problem.

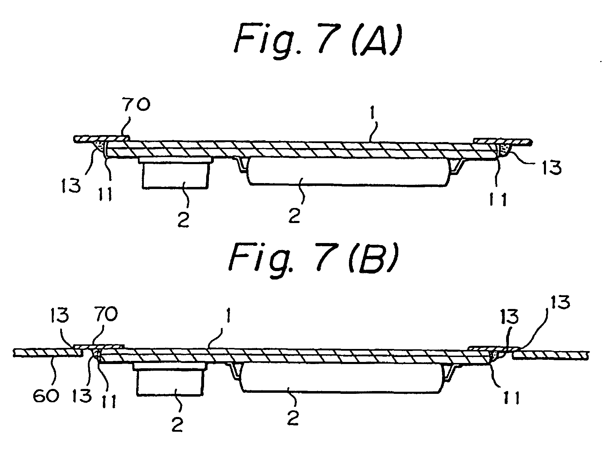

Figs.7A and 7B show the modification of the circuit of Figs.6A through 6D. The feature of Figs.7A and 7B is that a laminated body 1 is fixed to a mother board 60 upside down.

A laminated body in the circuits of Figs.6 and 7 has an inner wiring portion and may be that of Fig.3 which is molded with a semiconductor bare chip. Further, a laminated body in Figs.6 or 7 may mount semicondutor chips on both the surfaces of the same, although the drawings of Figs.6 and 7 show a laminated body which has a semiconductor chip 2 on only one surface.

## Claims

1. A method of producing a multi-layer hybrid circuit comprising the steps of :
providing a laminated body (1) having a plurality of passive elements including at least one selected from a capacitor layer (5) and an inductor layer (16), and also including a resistor layer (9),
said capacitor layer being produced by laminating a plurality of dielectric layers and conductive layers through thick film process so that said layers provide at least one capacitor,
said inductor layer being produced by laminating a plurality of magnetic layers and U-shaped conductive layers through thick film process so that the combination of said U-shaped layers provide a coil and the combination of said coil and said magnetic layers provide an inductor,
said resistor layer being produced by attaching an insulating layer on one surface of said laminated body which has at least one of said capacitor layer and said inductor layer, and attaching a resistive layer and conductive layer on said insulation layer through thick film process so that said resistor layer provides at least one resistor,
attaching a plurality of side terminals (11) on sides of said laminated body (1) for external connection of said passive elements and internal connection between said passive elements,
**characterized in that** it further comprises the steps of laminating an inner wiring portion (17) on said laminated body by laminating a plurality of insulation layers and flat conductive layers, said insulation layers having through holes (20) for electrically coupling said conductive layers on different layers of said inner wiring portion (17) to couple at least two of said passive elements,
and
sintering said laminated body at about 800°C, all of the steps prior to said attaching a plurality of side terminals (11) being performed without baking of the circuit being produced.

2. A method of producing a multi-layer hybrid circuit according to claim 1, further comprising the steps of depositing a conductive film (51) on one surface of said laminated body through thick film printing process, adhering an integrated circuit bare chip (31, 2), heating the laminated body at 150-160°C, placing the laminated body on a lead frame so that each of said side terminals couples with each lead terminal (33) of said lead frame, molding the laminated body together with said bare chip with plastics (34), and removing the outer portion of said lead frame.

## Patentansprüche

1. Verfahren zur Herstellung einer mehrschichtigen hybriden Schaltung, das folgende Schritte aufweist: die Ausbildung eines laminierten Körpers mit einer Vielzahl passiver Elemente, von denen wenigstens eines unter einer Kondensatorschicht (5) und einer induktiven Schicht (16) ausgewählt wird, und ferner mit einer ohmschen Widerstandsschicht (9), wobei die Kondensatorschicht durch Laminierung einer Vielzahl dielektrischer Schichten und leitender Schichten im Dickschichtverfahren hergestellt wird, so daß die Schichten wenigstens einen Kondensator bilden, wobei die induktive Schicht durch Laminierung einer Vielzahl magnetischer Schichten und U-förmiger leitender Schichten im Dickschichtverfahren hergestellt wird, so daß die Kombination der U-förmigen Schichten eine Spule und die Kombination aus der Spule und den magnetischen Schichten einen Induktor bildet, wobei die Widerstandsschicht durch Anbringung einer isolierenden Schicht auf der einen Oberfläche des laminierten Körpers, der die Kondensatorschicht und/oder Induktorschicht aufweist, und Anbringung einer ohmschen Widerstandsschicht und einer leitfähigen Schicht auf der Isolierschicht nach dem Dickschichtverfahren hergestellt wird, so daß die Widerstandsschicht wenigstens einen ohmschen Widerstand bildet; das Anbringen einer Vielzahl von seitlichen Anschlüssen (11) an den Seiten des laminierten Körpers (1) für eine externe Verbindung der passiven Elemente und eine interne Verbindung zwischen den passiven Elementen, **dadurch gekennzeichnet, daß** es ferner folgende Schritte aufweist: das Laminieren eines inneren Verdrahtungsteils (17) auf dem laminierten Körper durch Laminieren einer Vielzahl von Isolierschichten und flachen leitfähigen Schichten, wobei die Isolierschichten durchgehende Löcher (20) zum elektrischen Verbinden der leitfähigen Schichten auf verschiedenen Schichten des inneren Verdrahtungsteils (17) zum Verbinden wenigstens von zwei der passiven Elemente aufweisen, und das Sintern des laminierten Körpers bei etwa 800°C, wobei alle Schritte vor dem Anbringen einer Vielzahl seitlicher Anschlüsse (11) ohne Brennen der hergestellten Schaltung bewirkt wird.

2. Verfahren zur Herstellung einer mehrschichtigen hybriden Schaltung nach Anspruch 1, das ferner folgende Schritte aufweist: das Aufbringen einer leitfähigen Schicht (51) auf der einen Oberfläche des laminierten Körpers durch ein Dickschichtdruckverfahren, das Ankleben eines von einer integrieren Schaltung freien Chip (31, 2), das Erhitzen des laminierten Körpers bei 150 bis 160°C, das Anordnen des laminierten Körpers auf einem Leitungsrahmen, so daß jeder der seitlichen Anschlüsse mit jedem Leitungsanschluß (33) des Leitungsrahmens verbunden wird, das Zusammenformen des laminierten Körpers mit dem freien Chip mittels Kunststoff (34) und das Entfernen des äußeren Teils des Leitungsrahmens.

## Revendications

1. Procédé de production d'un circuit hybride multicouche comprenant les étapes consistant à :
fournir un corps stratifié (1) ayant une pluralité d'éléments passifs comprenant au moins une couche sélectionnée parmi une couche de condensateur (5) et une couche de bobine d'inductance (16), et comprenant aussi une couche de résistance (9),
ladite couche de condensateur étant obtenue en stratifiant une pluralité de couches diélectriques et de couches conductrices par un procédé à film épais de sorte que lesdites couches fournissent au moins un condensateur,
ladite couche de bobine d'inductance étant obtenue en stratifiant une pluralité de couches magnétiques et de couches conductrices en forme de U par un procédé à film épais de sorte que la combinaison desdites couches en forme de U fournisse une bobine et que la combinaison de ladite bobine et desdites couches magnétiques fournisse une bobine d'inductance,
ladite couche de résistance étant obtenue en appliquant une couche d'isolation sur une surface dudit corps stratifié lequel a au moins une de ladite couche de condensateur et de ladite couche de bobine d'inductance et l'application d'une couche résistive et d'une couche conductrice sur ladite couche d'isolation par un procédé à film épais de sorte que ladite couche de résistance fournisse au moins une résistance,
la fixation d'une pluralité de bornes latérales (11) sur les côtés dudit corps stratifié (1) pour le raccordement externe desdits éléments passifs et le raccordement interne entre lesdits éléments passifs,
**caractérisé en ce qu'**il comprend en outre les étapes consistant à stratifier une partie intérieure de câblage (17) sur ledit corps stratifié en stratifiant une pluralité de couches d'isolation et de couches plates conductrices, lesdites couches d'isolation ayant des trous traversants (20) pour coupler électriquement lesdites couches conductrices sur les différentes couches de ladite partie intérieure de câblage (17) pour coupler au moins deux desdits éléments passifs, et
le frittage dudit corps stratifié à environ 800°C, toutes les étapes antérieures à ladite fixation de la pluralité de bornes latérales (11) étant exécuté sans que la cuisson du circuit ne soit réalisée.

2. Procédé de fabrication d'un circuit hybride multicouche selon la revendication 1, comprenant en outre les étapes consistant à déposer un film conducteur (51) sur une surface dudit corps stratifié par un procédé d'impression de film épais, à coller une puce nue de circuit intégré (31, 2), à chauffer le corps stratifié à 150°C-160°C, à placer le corps stratifié sur une grille de connexion de sorte que chacune desdites bornes latérales se couple avec chaque borne de sortie (33) de ladite grille de connexion, à mouler ledit corps stratifié avec ladite puce nue à l'aide de plastique (34) et à enlever la partie extérieure de ladite grille de connexion.
